# EUROPEAN PATENT APPLICATION

(11) **EP 4 780 153 A1**
(43) Date of publication of application: **22.07.2026**
(21) Application number: 25152814.7
(22) Date of filing: 20.01.2025
(51) Int. Cl.: H05K 7/20

(54) **COOLING BLOCK FOR COOLING OF AN ELECTRONIC COMPONENT**

(71) Applicant: Connaught Electronics Ltd., County Galway H54 Y276 (IE)
(72) Inventor: KRISHNAMOORTHI, Preethkumar, 600130 Chennai (IN); DEEPAKARAN, Harish, 600130 Chennai (IN); RANA, Gyana-Ranjan, 600130 Chennai (IN); TROUT, Shane, Tuam, H54 Y276 (IE)
(74) Representative: Jauregui Urbahn, Kristian

(57) **Abstract**

Cooling block (1) for cooling an electronic component (14) of an electronic computing device (10) of a motor vehicle (15), wherein the cooling block (1) is applicable to a cooling channel (6) for guiding a cooling fluid. The cooling block (1) comprises an inlet side (2) on a first side of the cooling block (1). The cooling block (1) comprises an outlet side (3) on a second side of the cooling block (1). The cooling block (1) comprises a through hole (4) connecting the inlet side (2) to the outlet side (3) of the cooling block (1). The through hole (4) comprises an interior surface, which comprises a first protrusion (5a).

## Description

The invention relates to a cooling block for cooling an electronic component of an electronic computing device of a motor vehicle. The invention also relates to an electronic computing device with such a cooling block as well as to a motor vehicle with such an electronic computing device.

A motor vehicle typically comprises at least one electronic computing device with an electronic component. Particularly in connection with at least partially automated vehicles, there is a high-power requirement of the electronic computing device, which means that cooling of the electronic component of the electronic computing device is becoming increasingly relevant. Passive cooling systems are often not able to cool the electronic computing device sufficiently. For this reason, active cooling systems are particularly relevant, in which a cooling fluid, such as a cooling liquid, is guided through a cooling channel of an electronic computing device in order to quickly and reliably dissipate heat generated by the electronic component.

In computing and electronics, such as the electronic computing device, different methods of cooling the assembled electronic components are known. Especially for powerful components and for example for small installation spaces, the traditional air-cooling systems are not sufficient. In such cases heat, which is generated during operation of the assembled electronic components, may for example be dissipated by a cooling fluid. As the electronic component may not be designed to get in direct contact with the cooling fluid, a housing may be introduced to guide the cooling fluid in close proximity of the electronic component and establish a thermal connection to it. The housing may also comprise a cooling channel for guiding the cooling fluid. Especially for electronic computing devices with different electronic components the challenge might be to reach the individual electronic components, which generate the highest amount of heat and maximize the heat transfer in these regions.

It is an objective of the present invention to provide a solution by means of which an electronic component of an electronic computing device may be cooled with high cooling efficiency.

The objective is achieved by the subject matter of the independent claims. Further implementations and preferred embodiments are a subject matter of the dependent claims.

The invention is based on the idea, that the cooling fluid may dissipate the generated heat better, if the structure, which is guiding it, offers an improved thermal contact to the electronic component. This is achieved by a cooling block, which is applicable to a cooling channel and comprises a through hole with a protrusion, wherein the through hole is, in particular, interspersed with the protrusion.

According to an aspect of the invention, a cooling block for cooling an electronic component of an electronic computing device of a motor vehicle is provided. The cooling block is applicable to a cooling channel for guiding a cooling fluid. Furthermore, the cooling block comprises an inlet side on a first side of the cooling block and the cooling block comprises an outlet side on a second side of the cooling block. In addition, the cooling block comprises a through hole connecting the inlet side to the outlet side of the cooling block. Moreover, the through hole comprises an interior surface, which comprises a first protrusion.

In particular, the inlet side may correspond to the first side and the outlet side may correspond to the second side of the cooling block.

In other words, the cooling block may allow the cooling fluid to flow through the cooling block from the inlet side to the outlet side taking the through hole. The second side of the cooling block may for example be a different side from the first side of the cooling block. That the cooling block is applicable to the cooling channel may be understood such that the cooling block may be inserted in the cooling channel in a direction of flow of the cooling fluid in such a way, that the cooling fluid may enter the cooling block at the inlet side and exit the cooling block at the outlet side. In some embodiments, the cooling block, in particular its outer shape, may be reflectively symmetrical with respect to a plane parallel to the inlet side or to the outlet side and thus the placement of the cooling block in the cooling channel may be independent of the flow direction, especially the cooling fluid may also enter the cooling block at the outlet side and exit at the inlet side in principle.

The through hole may for example be generally shaped as a round through hole or essentially as a round through hole and the first protrusion may be bulged on the interior surface of the through hole towards a center of the through hole. The cooling block may be a single-piece component, meaning that the first protrusion may for example be part of the cooling block. Alternatively the first protrusion may also be attached and/or thermally connected to the interior surface of the through hole, such that the cooling block may be multiple-piece component. The through hole may be designed for guiding the cooling fluid.

A radial cross section of an outer shape of the first protrusion may for example comprise a first straight or essentially straight line and a second straight or essentially straight line, which may be parallel or essentially parallel to each other. Additionally the radial cross section of the outer shape of the first protrusion may comprise a third line. The third line may be straight or essentially straight and may be perpendicular or essentially perpendicular to the first and/or to the second line. Alternatively the third line may be curved or, for example, an arc of a circle. The radial cross section of the outer shape of the first protrusion may also comprise a fourth line, which may be curved, for example an arc of a further circle, and may run along a radius of the through hole. The fourth line may be a joint line with a further part of the cooling block and may be a geometric reference line. The geometric reference line is, in particular, not necessarily identifiable in a radial cross section of the cooling block.

The outer shape of the first protrusion may for example be a cuboid shape or an essentially cuboid shape, whereas a joint area of the first protrusion to the further part of the cooling block may for example have a shape of an edge of a part of a cylinder. The joint area may be a geometric reference area and not be identified in the radial cross section of the cooling block.

For example, the cuboid shape of the first protrusion or the essentially cuboid of the first protrusion shape may be a rectangular cuboid shape or an essentially rectangular cuboid shape. Especially the cuboid shape of the first protrusion may also be a cube shape in some embodiments.

The first side of the cooling block and the second side of the cooling block may be plane or approximately plane. In particular, the first side and the second side may be parallel to each other or perpendicular to each other. For example the cooling block may be of a cuboid shape or an essentially cuboid shape and the first side represents a first side face of the cuboid shape and the second side represents a second side face of the cuboid shape. Alternatively the cooling block may of an irregular shape. The irregular shape may be adapted to the cooling channel, which it may be designed for, and optimized for inserting into the cooling channel. For example, the cuboid shape of the cooling block may be a rectangular cuboid shape. In this case the inlet side and the outlet side may be parallel to each other. Especially the cuboid shape may also be a cube shape in some embodiments.

Heat generated by the electronic component, which may for example be placed in direct proximity of the cooling block and may be in thermal contact with the cooling block, may be dissipated by means of a heat transport with the cooling fluid. It may be provided that there is no direct mechanical contact between the cooling block and the electronic component, but a thermal contact via a housing, the cooling channel, an additional cooling device or the like. In other embodiments, there may be a direct mechanical contact between the cooling block and the electronic component. The cooling channel may also be referred to as a heat sink or the like.

The cooling fluid may comprise a liquid coolant, such as for example water, oil, or a special cooling liquid for cooling electronic systems. The cooling fluid may also be gaseous, such as air or a special gas for cooling electronic systems.

An advantage of the cooling block according to the invention is the improved heat dissipation of the heat of the electronic component. Thus, a particularly stable operation for is possible for the electronic component, which might generate large amounts of heat. With the introduced invention, a more powerful electronic component may be integrated in a motor vehicle without having a risk of overheating the respective component or degrading the lifetime of the component.

By inserting the cooling block in the cooling channel, for example, the through hole in the section of the cooling block locally increases a flow velocity of the cooling fluid compared to a cooling channel without a cooling block. This increases the heat transport by convection. The electronic component may therefore be cooled with high cooling efficiency using the cooling block.

The first protrusion will increase an overall surface of the cooling block, which is in contact with the cooling fluid. The protrusion will also increase a flow velocity of the cooling fluid along the cooling block and further increase the heat transport by convection compared to a through hole without the first protrusion. Additionally the first protrusion may introduce a turbulence to a flow of the cooling fluid and increase the heat transport by the turbulence. This will have a positive influence on the cooling efficiency.

According to at least one embodiment, the cooling block may consist of one piece or of several pieces, which may be assembled subsequently to the manufacturing process of each of the several pieces.

According to at least one embodiment, the cooling block comprises or consists of a thermally conductive material, for example a metal. This may enhance the heat dissipation.

According to at least one embodiment, the through hole including the first protrusion corresponds to a recess from the die-casting process in case the cooling block is a die-casted part or the through hole including the first protrusion corresponds to a generated cavity, for example a machined or drilled hole. For example, the cooling block may in a first step be manufactured as a solid element and the through hole including the protrusion may be generated subsequently in a second step.

The through hole may also be referred to as a mini-channel or a micro-channel in comparison to the cooling channel, which may for example comprise a larger cavity in order to at least partly enclose the cooling channel. The cooling block may also be produced in a 3D printing process or a metal 3D printing process.

According to at least one further embodiment, the dimensions of the cooling block may be for example in the range of 20 mm to 100 mm in each direction with a typical value of 50 mm. Therein the dimensions in each direction may vary.

According to at least one embodiment, a hole diameter of the through hole may for example be in the range of 1 mm to 20 mm, with a typical value of 6 mm to 10 mm.

According to at least one further embodiment the first protrusion extends longitudinally along a center line of the through hole over a first longitudinal length starting at a first longitudinal position. The first protrusion extends radially to the center line of the through hole from a first inner radius to an outer radius of the through hole. The first protrusion extends along a circumference of the through hole over a first angle beginning at a first circular position at the outer radius.

In particular the center line may be a straight line and the through hole may run along the straight line. In particular, the center line may be denoted as a center axis and the first protrusion may extend axially along the center axis. Alternatively the center line may be a curved line.

The radial extension may correspond to an extension in a cross section of the through hole, which may be defined as a radial plane, which is locally perpendicular to center line. The outer radius may run on the radial plane.

The extension of the first protrusion radially to the center line, may also be referred to as a transversal extension of the first protrusion. In case the third line of the first protrusion is straight, the third line may be a tangential line at the first inner radius and the first protrusion may extend from the tangential line to the outer radius.

A first surface of the first protrusion may be located at the first longitudinal position and may be parallel or essentially parallel to a radial cross section of the through hole. The first surface may be sloped towards a main direction of the through hole. A second surface of the first protrusion may be located on an opposite side of the first surface and may be parallel or essentially parallel to the radial cross section of the through hole. The second surface may be reversely sloped compared to the first surface. In case both the first surface and the second surface are sloped towards each other, the shape of the first protrusion may be a pyramidal shape seen from a longitudinal cross section of the through hole.

The first protrusion may comprise a plurality of edges and each of the plurality of edges may be chamfered or rounded.

The first longitudinal length may be shorter than a longitudinal length of the cooling block in the direction of the through hole, in particular the first longitudinal length may be 1/2 to 1/10 of the longitudinal length of the cooling block. The first longitudinal length may for example be in the range of 5 mm to 10 mm.

If the through hole may be shaped as the round through hole, which may be interrupted by the first protrusion, the outer radius may be half of the hole diameter of the through hole. The first inner radius may be smaller than the outer radius. The first inner radius may be in the range of ½ to 1/10 of the outer radius.

For example, the first angle may be in a range of 10° to 60°, with a typical value of 25°.

An advantage of the described embodiments is the flexible placement of the first protrusion within the through hole and the further increased transport of the heat by the cooling block.

According to at least one further embodiment, the cooling block comprises at least one first further protrusion, wherein each of the at least one first further protrusion extends longitudinally along the center line of the through hole over the first longitudinal length starting at the first longitudinal position. Also each of the at least one first further protrusion extends radially to the center line of the through hole from the first inner radius to the outer radius of the through hole. Additionally each of the at least one first further protrusion extends along the circumference of the through hole over the first angle beginning at a respective first further circular position at the outer radius.

For example the at least one first further protrusion may comprise the same features as described for the first protrusion. Alternatively, some or all of the at least one first further protrusion may differ from these features.

The first protrusion and each of the at least one first further protrusion may be separated from each other, meaning, that there is no overlap between any protrusions.

In particular, a number of the at least one first further protrusion may be three. In addition with the first protrusion, thus a total number of first protrusions may be four.

An advantage of the described embodiments is the flexible placement of the total number of first protrusions within the through hole and the further increased transport of the heat by the cooling block.

According to at least one further embodiment, the first circular position and each of the first further circular position of the at least one first further protrusion is spaced equidistantly over the circumference of the through hole.

In particular, if the total number of first protrusions is four, an angular distance between each of the first circular position and the at least first further position may be 90°. In this case the first angle may be smaller than 90°, with a typical value of 20° to 30°.

An advantage of the described embodiments is the flexible placement of the total number of first protrusions within the through hole and the further increased transport of the heat by the cooling block. The manufacturing process may be optimized with the described embodiments.

According to at least one further embodiment the cooling block comprises a second protrusion, which extends longitudinally along the center line of the through hole over a second longitudinal length starting at a second longitudinal position. The second protrusion extends radially to the center line of the through hole from a second inner radius to the outer radius of the through hole. The second protrusion extends along the circumference of the through hole over a second angle beginning at a second circular position at the outer radius.

For example the second protrusion may comprise the same features as described for the first protrusion. Alternatively, the second protrusion may differ from these features.

The first protrusion and the second protrusion may be separated from each other, meaning, that there is no overlap between each protrusion.

In particular, a distance between the second longitudinal position and the first longitudinal position may be in a greater than the first longitudinal length. Thus, the first protrusion and the second protrusion may be placed on different radial planes of the through hole.

In particular, the first longitudinal length and the second longitudinal length may be different. In particular, the first longitudinal position and the second longitudinal position may be different. In particular, the first inner radius and the second inner radius may be different. In particular, the first angle and the second angle may be different. In particular, the first circular position and the second circular position may be different.

An advantage of the described embodiments is the flexible placement of the second protrusion within the through hole and the further increased transport of the heat by the cooling block.

According to at least one further embodiment, the cooling block comprises at least one second further protrusion, wherein each of the at least one second further protrusion extends longitudinally along the center line of the through hole over the second longitudinal length starting at the second longitudinal position. Also, each of the at least one second further protrusion extends radially to the center line of the through hole from the second inner radius to the outer radius of the through hole. Additionally, each of the at least one second further protrusion extends along the circumference of the through hole over the second angle beginning at a respective second further circular position at the outer radius.

For example, the at least one second further protrusion may comprise the same features as described for the first protrusion. Alternatively, some or all of the at least one second further protrusion may differ from these features.

The second protrusion and each of the at least one second further protrusion may be separated from each other, meaning, that there is no overlap between each protrusion.

In particular, a number of the at least one second further protrusion may be three. In addition with the second protrusion, thus a total number of second protrusions may be four.

An advantage of the described embodiments is the flexible placement of the total number of second protrusions within the through hole and the further increased transport of the heat by the cooling block.

According to at least one further embodiment the second circular position and each of the second further circular position of the at least one second further protrusion are spaced equidistantly over the circumference of the through hole.

In particular, if the total number of second protrusions is four, an angular distance between each of the second circular position and the at least second further position may be 90°. In this case the second angle may be smaller than 90°, with a typical value of 20° to 30°.

An advantage of the described embodiments is the flexible placement of the total number of second protrusions within the through hole and the further increased transport of the heat by the cooling block. The manufacturing process may be optimized with the described embodiments.

According to at least one further embodiment, the cooling block comprises at least one third further protrusion, wherein each of the at least one third further protrusion extends longitudinally along the center line of the through hole over the first longitudinal length starting at a respective first further longitudinal position. Also each of the at least one third further protrusion extends radially to the center line of the through hole from the first inner radius to the outer radius of the through hole. Additionally each of the at least one third further protrusion extends along the circumference of the through hole over the first angle beginning at the first circular position at the outer radius.

According to at least one further embodiment, the cooling block comprises at least one fourth further protrusion, wherein each of the at least one fourth further protrusion extends longitudinally along the center line of the through hole over the second longitudinal length starting at a respective second further longitudinal position. Also each of the at least one fourth further protrusion extends radially to the center line of the through hole from the second inner radius to the outer radius of the through hole. Additionally each of the at least one fourth further protrusion extends along the circumference of the through hole over the second angle beginning at the second circular position at the outer radius.

According to at least one further embodiment, the cooling block may comprise at least one fifth further protrusion, wherein each of the at least one fifth further protrusion extends longitudinally along the center line of the through hole over the first longitudinal length starting at each of the respective first further longitudinal position of the at least one third further protrusion. Also each of the at least one fifth further protrusion extends radially to the center line of the through hole from the first inner radius to the outer radius of the through hole. Additionally each of the at least one fifth further protrusion extends along the circumference of the through hole over the first angle beginning at the respective first further circular position at the outer radius.

According to at least one further embodiment, the cooling block may comprise at least one sixth further protrusion, wherein each of the at least one sixth further protrusion extends longitudinally along the center line of the through hole over the second longitudinal length starting at each of the second further longitudinal position of the at least one fourth further protrusion. Also each of the at least one sixth further protrusion extends radially to the center line of the through hole from the second inner radius to the outer radius of the through hole. Additionally each of the at least one sixth further protrusion extends along the circumference of the through hole over the second angle beginning at the respective second further circular position at the outer radius.

According to at least one further embodiment the first longitudinal position, each of the first further longitudinal position of the at least one third further protrusion, the second longitudinal position and each of the second further longitudinal position of the at least one fourth further protrusion are spaced equidistantly over a length of the through hole.

According to at least one further embodiment each of the first further circular position of the at least one fifth further protrusion and each of the second further circular position of the at least one sixth further protrusion are spaced equidistantly over the circumference of the through hole.

For example the at least one third further protrusion and the at least one fourth further protrusion may comprise the same features as described for the first protrusion. Alternatively, some or all of the at least one third further protrusion and/or some or all of the at least one fourth further protrusion may differ from these features.

For example the at least one fifth further protrusion and the at least one sixth further protrusion may comprise the same features as described for the first protrusion . Alternatively, some or all of the at least one fifth further protrusion and some or all of the at least one sixth further protrusion may differ from these features.

The first protrusion, the second protrusion, each of the at least one first further protrusion, each of the at least one second further protrusion, each of the at least one third further protrusion, each of the at least one fourth further protrusion, each of the at least one fifth further protrusion and each of the at least one sixth further protrusion may be separated from each other, meaning, that there is no overlap between any protrusions.

An advantage of the described embodiments is the flexible placement of a total number of protrusions including the first protrusion, the at least one first further protrusion, the second protrusion, the at least one second further protrusion, the at least one third further protrusion and the at least one fourth further protrusion within the through hole and the further increased transport of the heat by the cooling block.

According to at least one further embodiment the cooling block comprises copper and/or a copper alloy and/or aluminum and/or an aluminum alloy.

The cooling block may for example consist of copper and/or the copper alloy and/or aluminum and/or the aluminum alloy.

An advantage of this embodiment is the easy manufacturing process and the superior thermal conductivity of copper, the copper alloy, aluminum and the aluminum alloy.

A further aspect of the invention relates to a cooling block array comprising at least two cooling blocks according to the invention. Each respective first side of the at least two cooling blocks is parallel to all other respective first sides of the at least two cooling blocks. In addition, the at least two cooling blocks are thermally connected to each other.

The cooling block array may be designed in one piece. Thus, the at least two cooling blocks may be geometrical parts of one single unit and may especially not be mechanically separable without destroying the cooling block array. In alternative embodiments, the cooling block array may also be a joined part consisting of individual at least two cooling blocks. The at least two cooling blocks may in this case be joined for example with an adhesive process or welded in order to form the cooling block array.

The at least two cooling blocks may be in thermal contact to each other as well as in thermal contact to the electronic component.

An advantage of the cooling block array is the high heat load that can be transported away from the electronic component. The throughput of the cooling fluid may be high and enable an intensive cooling process.

By inserting the cooling block array in the cooling channel, for example, the flow velocity of the cooling fluid is high, while at the same time the amount of cooling fluid is increased compared to a single cooling block. The electronic component may therefore be cooled with high cooling efficiency using the cooling block array.

A further aspect of the invention relates to an electronic computing device for a motor vehicle comprising a housing and an electronic component. The housing comprises or forms a cooling channel for guiding a cooling fluid. The housing also comprises a cooling block according to the invention or a cooling block array according to the invention. The cooling block or the cooling block array is located in the cooling channel and the electronic component is thermally connected to the cooling block or the cooling block array.

The housing may comprise or consist of a metal such as aluminum or the aluminum alloy. It may for example also comprise or consist of a plastic compound material. The housing may for example form the cooling channel as a recess in a lower housing. Alternatively, the cooling channel may also be a separate part, which can be assembled to the housing.

The housing may for example comprise an inlet connection in order to supply the housing with the cooling fluid. The cooling channel may receive the cooling fluid from the housing or directly from the inlet connection. The cooling fluid may be able to flow through the cooling channel and thus through the cooling block from the inlet side to the outlet side or through the cooling block array. Additionally the cooling fluid may exit the cooling channel. The cooling fluid may subsequently exit the housing for example via an outlet connection. Alternatively, the cooling fluid may flow through the electronic computing device in an opposite direction.

A thermal contact between the electronic component and the cooling block or the cooling block array may be achieved for example by transmitting the heat via a thermally conductive part of the housing and/or the cooling channel. The electronic component may for example be placed within the housing.

The inlet connection may for example be connected to a source for providing the cooling fluid wherein the source is arranged separately to the electronic computing device in the motor vehicle. Furthermore, the outlet connection may for example be connected to a corresponding drain for the cooling fluid, wherein the drain is also arranged externally to the electronic computing device in the motor vehicle. The motor vehicle may, for example, comprise means for recirculating or conditioning or re-cooling of the cooling fluid received by the drain from the outlet connection and provided again via the source to the inlet connection. To this end, the motor vehicle may also comprise a transportation system for the cooling fluid including, for example, one or more pumps to convey the cooling fluid from the source to the inlet connection through the housing back to the outlet connection and the drain and so forth.

Consequently, the supply of the electronic computing device with the cooling fluid may be implemented in a particularly compact way by providing the housing according to the invention. The electronic computing unit may be placed within the motor vehicle in various places as it may be largely protected from environmental influences.

According to at least one embodiment the electronic computing device may for example comprise an electronic computing unit (ECU), a zonal controller unit (ZCU) or a domain controller unit (DCU). According to at least one embodiment, it is provided that the electronic computing device is part of a vehicle-centric, zone-oriented architecture of electrical and/or electronic components of the motor vehicle.

In particular, at least one main controller, for example a single main controller, may be provided in the vehicle architecture, which may also be referred to as the main control unit or vehicle computer, and which may be designed to perform main computing operations for vehicle-specific applications, for example autonomous driving and/or driver assistance functions.

The main controller may be connected to several, for example two to six, in particular four, zonal controllers, which may also be referred to as zone controllers or zonal control units, ZCUs, by means of a wired and/or wireless communication technology. Zonal controllers may be designed to perform less demanding computing operations compared to the main computing operations of the main controller.

For example, the electronic vehicle architecture can be divided into zones, for example four zones, wherein a zonal controller can be provided for each of the zones. In particular, the main controller can be connected via the zonal controllers to other electrical and/or electronic components of the motor vehicle, in particular to smaller, distributed control units, sensors and/or actuators of the motor vehicle.

Such a vehicle-centric, zone-oriented architecture of the electrical or electronic components can be beneficial since it may be less complex than a domain-oriented architecture. In particular, the computing operations of the complex, vehicle-specific applications of distributed control units can be consolidated on a single or on a few, very powerful main controllers.

For example, the electronic computing device according to the invention may be a main controller of the motor vehicle. Alternatively, the electronic computing device according to the invention may be a zonal controller of the motor vehicle or a domain controller of the motor vehicle.

According to at least one further embodiment the electronic component comprises a system-on-chip and/or a system-in-package.

The system-on-chip may be an integrated circuit that integrates most or all components of a computer or other electronic system. The system-on-chip may for example comprise an on-chip central processing unit (CPU), memory interfaces, input/output devices and interfaces, and secondary storage interfaces, often alongside other components such as radio modems and a graphics processing unit (GPU).

The system-in-package may for example comprise a number of integrated circuits enclosed in one chip carrier package. The system-in-package may for example include passive components and perform the functions of an entire system. The number of integrated circuits may be stacked using package on package, placed side by side, and/or embedded in a substrate.

Both the system-on-chip and the system-in-package may feature a high computing power, which may for example result in a high heat dissipation respectively.

An advantage of described electronic components is a high integration density and at the same time an effective cooling mechanism within the electronic computing device.

According to at least one further embodiment, a thermal conductivity of the cooling block and/or the cooling block array is equal to or greater than a thermal conductivity of cooling channel walls spatially limiting the cooling channel.

If the cooling channel is part of the housing, the cooling channel walls may be part of the housing as well. A shape of the cooling channel walls may for example be designed to guide the cooling fluid through the cooling channel. Especially, the cooling channel walls are in direct contact with the cooling fluid. The shape of the cooling channel walls may be designed to at least partly enclose the cooling block and/or the cooling block array.

When assembled to the cooling channel, the cooling block and/or the cooling block array may be fixed in a position with the cooling channel. The dynamic behavior of the cooling fluid may not influence the position of the cooling block and/or the cooling block array.

An advantage of this embodiment is a concentration of effective cooling at the cooling block and/or at the cooling block array. By selective assembly of the cooling block and/or the cooling block array within the cooling channel a highest cooling power can be located at desired positions.

According to at least one further embodiment, the housing comprises a cover and the cover is attached to the cooling channel, wherein the cover seals the cooling channel in a fluid-tight manner and the electronic component and the cooling block are arranged on opposite sides of the cooling channel.

Especially the fluid-tight manner may be related to all sides of the cover and the cooling channel except for the inlet connection and the outlet connection. In an assembled status the cooling fluid may for example be able to flow from the inlet connection through the housing to the outlet connection or vice versa.

Fluid-tight may be understood as watertight and/or airtight, especially tight to the cooling fluid.

The housing may also comprise the lower housing and an upper housing. A combination of the cover and the cooling channel may be enclosed by the lower housing and the upper housing.

The cooling block may be attached to a first side of the cooling channel. The electronic component may for example be attached to a second side of the cooling channel, which may not be in direct contact with the cooling fluid.

An advantage of this embodiment is a compact design, which enables thermal contact from the electronic component to the cooling fluid, but at the same time protects the electronic component from direct contact to fluids.

A further aspect of the invention relates to a motor vehicle comprising an electronic computing device according to the invention.

In some implementations, the motor vehicle may comprise the source and/or the drain for the cooling fluid and, for example, the transportation system for supplying the electronic computing device with the cooling fluid and for draining the cooling fluid from the electronic computing device.

Further features of the invention are evident from the claims, the figures, and the description of the figures. The features and feature combinations previously mentioned in the description as well as the features and the feature combinations mentioned in the following in the description of the figures and/or shown in the figures may be contained by the invention not only in the respective indicated combination, but also in other combinations. In particular, embodiments and feature combinations, which do not comprise all features of an originally formulated claim, are also comprised by the invention. Moreover, embodiments and feature combinations, which go beyond the feature combinations set out in the recitations of the claims or deviate from these, are comprised by the invention.

In the following the invention is explained in detail with regard to special exemplary implementations and respective schematic drawings. In the drawings, identical or functionally identical elements may be equipped with the same reference signs. The description of identical or functionally identical elements is not necessarily repeated with regard to various figures.

In the figures:
- Fig. 1: shows a schematic representation of an exemplary implementation of a cooling block within a cooling channel according to the invention;
- Fig. 2a: shows a perspective view of an exemplary implementation of a cooling block according to the invention;
- Fig. 2b: shows a front view of a further exemplary implementation of a cooling block according to the invention;
- Fig. 2c: shows a front view of a further exemplary implementation of a cooling block according to the invention;
- Fig. 3: shows a cross-sectional view of a further exemplary implementation of a cooling block according to the invention;
- Fig. 4: shows a perspective view of an exemplary implementation of a cooling block array according to the invention;
- Fig. 5: shows a front view of a further exemplary implementation of a cooling block array according to the invention;
- Fig. 6: shows a perspective view of an exemplary implementation of an electronic computing device according to the invention;
- Fig. 7: shows an explosion view of the electronic computing device of Fig. 6; and
- Fig. 8: shows a schematic representation of an exemplary implementation of a motor vehicle according to the invention.

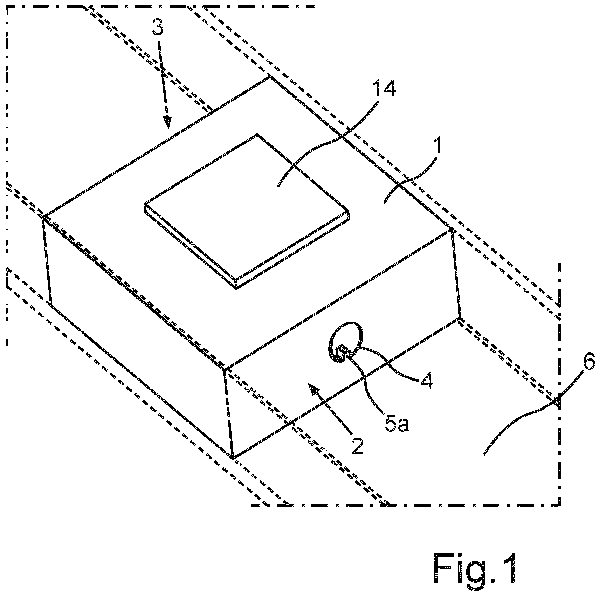

Fig. 1 shows schematically a cooling block 1 for cooling an electronic component 14 of an electronic computing device 10 of a motor vehicle 15 according to the invention. The cooling block 1 is applicable to a cooling channel 6 for guiding a cooling fluid. In Fig. 1, an example of this assembly is shown. The cooling block 1 comprises an inlet side 2 on a first side of the cooling block 1 and an outlet side 3 on a second side of the cooling block 1. Additionally, the cooling block 1 comprises a through hole 4 connecting the inlet side 2 to the outlet side 3 of the cooling block 1. The through hole 4 comprises an interior surface, which comprises a first protrusion 5a.

The cooling channel 6 may enclose the cooling block 1 at least partially, so that the cooling fluid may flow through the cooling channel 6 and may be forced to flow through the cooling block 1. The cooling fluid may flow through the through hole 4 from the inlet side 2 to the outlet side 3. The electronic component 14 may for example be placed directly next to the cooling block 1 or be placed in a thermic surrounding of the cooling block 1 so that the electronic component 14 is thermally connected to the cooling block 1.

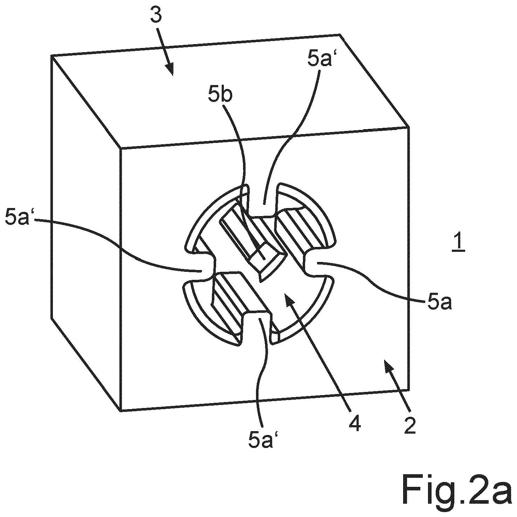

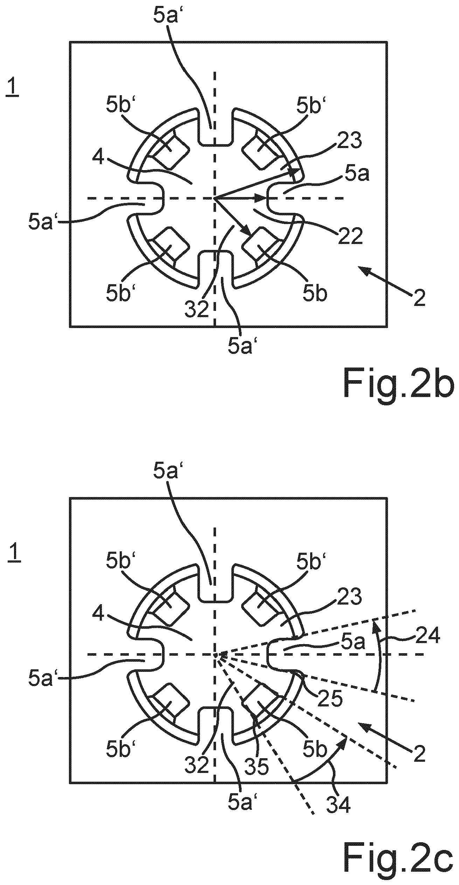

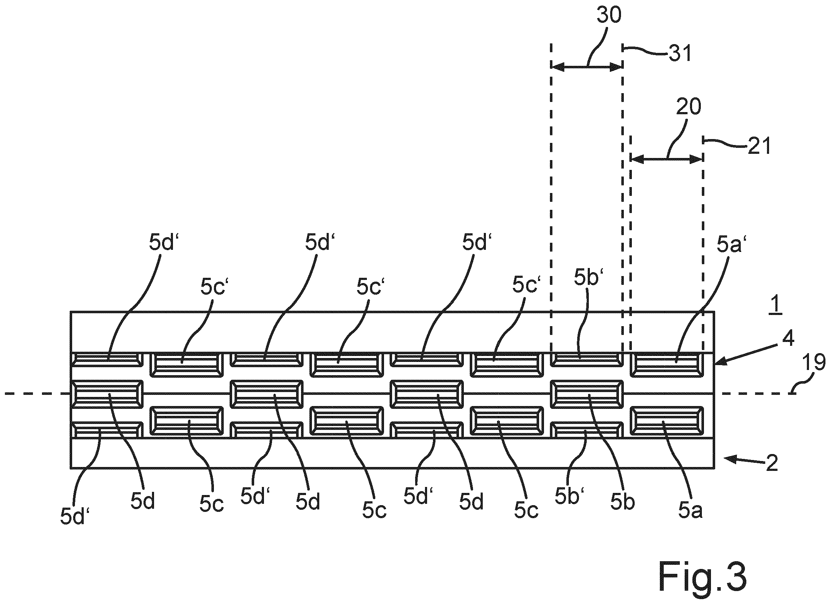

Fig. 2a, 2b, 2c and 3 show schematically a further embodiment of the cooling block 1 according to the invention. The cooling block 1 may comprise the through hole 4, which may comprise the first protrusion 5a. Fig. 2a shows a perspective view of the cooling block 1, which may comprise at least one first further protrusion 5a' and a second protrusion 5b. For example a number of the at least one first further protrusion 5a' may be three as shown in Fig. 2a, thus a total number of first protrusions, including the first protrusion 5a and the at least one first further protrusion 5a' may for example be four.

A longitudinal view of the cooling block 1 is shown in Fig. 3. The first protrusion 5a may extend longitudinally along a center line 19 of the through hole 4 over a first longitudinal length 20 starting at a first longitudinal position 21. A radial view of the cooling block 1 is shown in Fig. 2b. The first protrusion 5a may extend radially to the center line 19 of the through hole 4 from a first inner radius 22 to an outer radius 23 of the through hole 4. A circumferential view of the cooling block 1 is shown in Fig. 2c. The first protrusion 5a may extend along a circumference of the through hole 4 over a first angle 24 beginning at a first circular position 25 at the outer radius 23.

Each of the at least one first further protrusion 5a' may extend longitudinally along the center line 19 of the through hole 4 over the first longitudinal length 20 starting at the first longitudinal position 21. Each of the at least one first further protrusion 5a' may extend radially to the center line 19 of the through hole 4 from the first inner radius 22 to the outer radius 23 of the through hole 4. Each of the at least one first further protrusion 5a' may extend along the circumference of the through hole 4 over the first angle 24 beginning at a respective first further circular position at the outer radius 23.

The first circular position 25 and each of the first further circular position of the at least one first further protrusion 5a' may be spaced equidistantly over the circumference of the through hole 4. An angular distance of the first circular position 25 and each first further circular position of the at least one first further protrusion 5a' may be 90°.

The second protrusion 5b may extend longitudinally along the center line 19 of the through hole 4 over a second longitudinal length 30 starting at a second longitudinal position 31. The second protrusion may extend radially to the center line 19 of the through hole 4 from a second inner radius 32 to the outer radius 23 of the through hole 4. The second protrusion 5b may extend along the circumference of the through hole 4 over a second angle 34 beginning at a second circular position 35 at the outer radius 23.

The cooling block 1 may comprise at least one second further protrusion 5b'. Each of the at least one second further protrusion 5b' may extend longitudinally along the center line 19 of the through hole 4 over the second longitudinal length 30 starting at the second longitudinal position 31. Each of the at least one second further protrusion 5b' may extend radially to the center line 19 of the through hole 4 from the second inner radius 32 to the outer radius 23 of the through hole 4. Each of the at least one second further protrusion 5b' may extend along the circumference of the through hole 4 over the second angle 34 beginning at a respective second further circular position at the outer radius 23.

The second circular position 35 and each of the second further circular position of the at least one second further protrusion 5b' may be spaced equidistantly over the circumference of the through hole 4. An angular distance of the second circular position 35 and each second further circular position of the at least one first further protrusion 5a' may be 90°. In particular an angular distance of the first circular position 25 and the second circular position 35 may be 45°.

Fig. 3 shows a possible longitudinal continuation of the through hole 4 along the center line 19 according to a further exemplary embodiment.

The cooling block 1 may comprise at least one third further protrusion 5c. Each of the at least one third further protrusion 5c may extend longitudinally along the center line 19 of the through hole 4 over the first longitudinal length 20 starting at a respective first further longitudinal position. Each of the at least one third further protrusion 5c may extend radially to the center line 19 of the through hole 4 from the first inner radius 22 to the outer radius 23 of the through hole 4. Each of the at least one third further protrusion 5c may extend along the circumference of the through hole 4 over the first angle 24 beginning at the first circular position 25 at the outer radius 23.

The cooling block 1 may comprise at least one fourth further protrusion 5d. Each of the at least one fourth further protrusion 5d may extend longitudinally along the center line 19 of the through hole 4 over the second longitudinal length 30 starting at a respective second further longitudinal position. Each of the at least one fourth further protrusion 5d may extend radially to the center line 19 of the through hole 4 from the second inner radius 32 to the outer radius 23 of the through hole 4. Each of the at least one fourth further protrusion 5d may extend along the circumference of the through hole 4 over the second angle 34 beginning at the second circular position 35 at the outer radius 23.

The cooling block 1 may comprise at least one fifth further protrusion 5c', wherein each of the at least one fifth further protrusion 5c' extends longitudinally along the center line 19 of the through hole 4 over the first longitudinal length 20 starting at each of the respective first further longitudinal position of the at least one third further protrusion 5c. Also each of the at least one fifth further protrusion 5c' extends radially to the center line 19 of the through hole 4 from the first inner radius 22 to the outer radius 23 of the through hole 4. Additionally each of the at least one fifth further protrusion 5c' extends along the circumference of the through hole 4 over the first angle 24 beginning at the respective first further circular position at the outer radius 23.

The cooling block 1 may comprise at least one sixth further protrusion 5d', wherein each of the at least one sixth further protrusion 5d' extends longitudinally along the center line 19 of the through hole 4 over the second longitudinal length 30 starting at each of the second further longitudinal position of the at least one fourth further protrusion 5d. Also each of the at least one sixth further protrusion 5d' extends radially to the center line 19 of the through hole 4 from the second inner radius 32 to the outer radius 23 of the through hole 4. Additionally each of the at least one sixth further protrusion 5d' extends along the circumference of the through hole 4 over the second angle 34 beginning at the respective second further circular position at the outer radius 23.

The first longitudinal position 21, each of the first further longitudinal position of the at least one third further protrusion 5c, the second longitudinal position 31 and each of the second further longitudinal position of the at least one fourth further protrusion 5d may be spaced equidistantly over a length of the through hole 4.

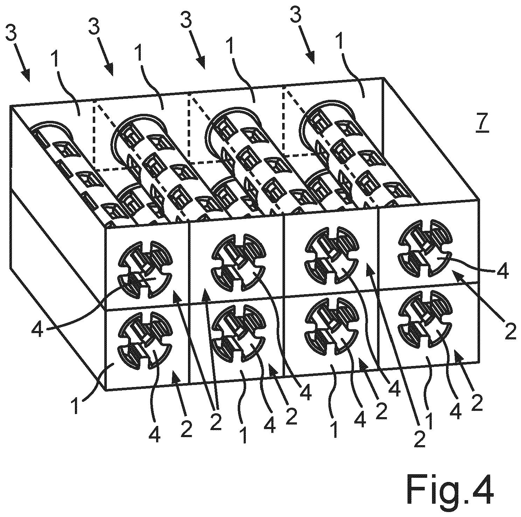

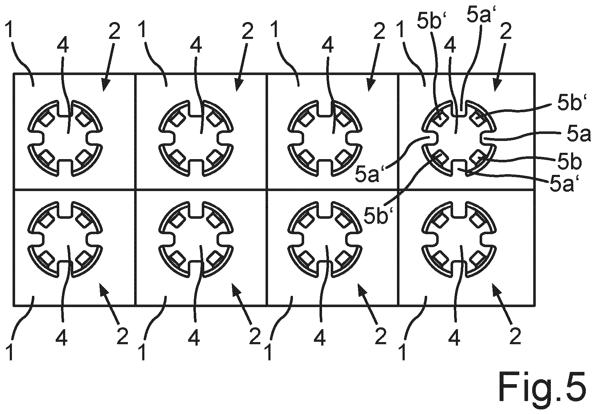

Fig. 4 and 5 show an implementation of the cooling block array 7 according to the invention. The cooling block array 7 may comprise at least two cooling blocks 1, which are connected to each other. In this example the cooling block array 7 consists of eight cooling blocks 1. Each cooling block 1 may be a geometric unit but is not necessarily an individual part. The cooling block array 7 may be one single part. Each inlet side 2 of the at least two cooling blocks 1 may flush with every other inlet side 2 of the at least two cooling blocks 1. In at least one other embodiment it may be advantageous, that one or more inlet sides 2 of the at least two cooling blocks 1 may protrude from the other inlet sides 2. Same applies to the outlet sides 3.

Fig. 4 shows for each cooling block 1 the through hole 4 and the first protrusion 5a, the at least one first further protrusion 5a', the second protrusion 5b, the at least one second further protrusion 5b', the at least one third further protrusion 5c, the at least one fourth further protrusion 5d, the at least one fifth further protrusion 5c' and the at least one sixth further protrusion 5d'.

Fig. 5 shows for each cooling block 1 the through hole 4 and the first protrusion 5a, the at least one first further protrusion 5a', the second protrusion 5b and the at least one second further protrusion 5b'.

A geometry of each cooling block 1 of the cooling block array 7 may vary in terms of a placement, a diameter of through holes 4 or a shape or size of one of the protrusions. The geometry may be reflectively symmetrical with respect to a plane parallel to the inlet side 2 or to the outlet side 3, so that the cooling fluid may flow from the inlet side 2 to the outlet side 3 or vice versa.

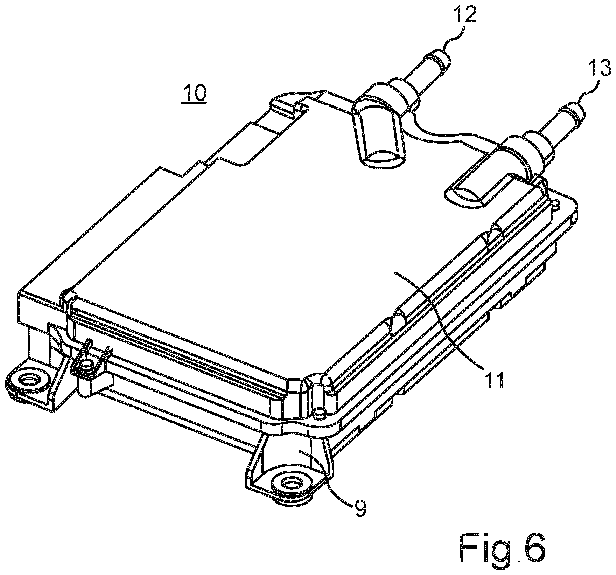

Fig. 6 shows a perspective view of an exemplary embodiment of an electronic computing device 10 according to the invention. The electronic computing device 10 may comprise a housing and an electronic component 14 (not shown). The housing may comprise an inlet connection 12, an outlet connection 13, a lower housing 9 and an upper housing 11. The housing may seal the electronic computing device 10 in a fluid tight manner except for the inlet connection 12 and the outlet connection 13, which may be prepared to exchange cooling fluid with a transportation system for supplying the electronic computing device 10 with the cooling fluid and for draining the cooling fluid from the electronic computing device 10.

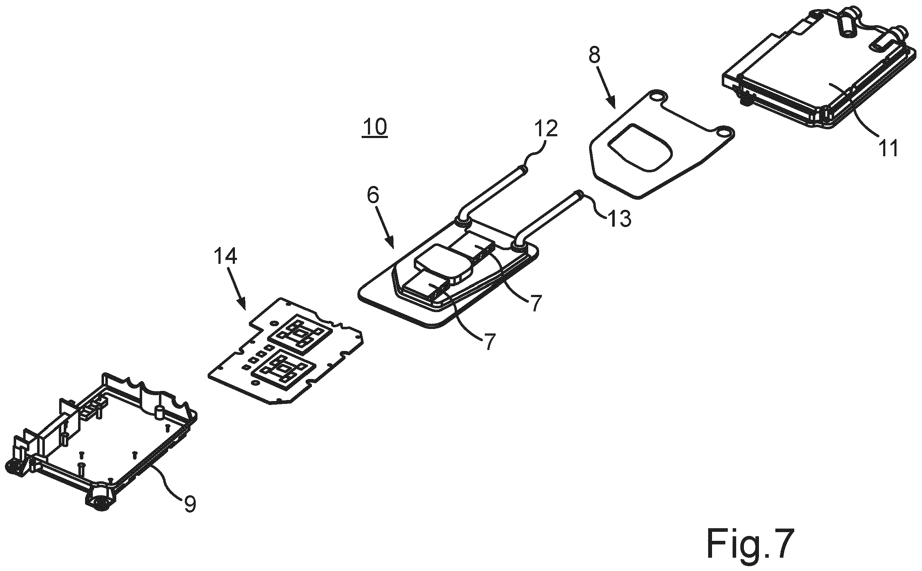

Fig. 7 shows an exploded view of the exemplary embodiment of the electronic computing device 10, which is shown in Fig. 6. The housing may comprise the cooling channel 6, the cooling block 1 and/or the cooling block array 7 and a cover 8. The cooling block 1 and/or the cooling block array 7 may be arranged within the cooling channel 6, such that the cooling fluid, which may enter the housing at the inlet connection 12, may flow through the cooling channel 6, the cooling block 1 and/or the cooling block array 7 and may exit the housing at the outlet connection 13.

The cover 8 may be prepared to be mounted on top of the cooling channel 6. If mounted the cover 8 may seal the cooling channel 6 in a fluid tight manner, such that the cooling fluid may not exit a combination of the cooling channel 6 and the cover 8 other than through the inlet connection 12 or the outlet connection 13.

The electronic component 14 may be placed on an opposite side of the cooling channel 6 in comparison to the cooling block 1, the cooling block array 7 and the cover 8. The electronic component 14 may be placed in a vicinity of the cooling block 1 or the cooling block array 7, such that a thermal contact is enabled between the electronic component 14 as a heat source and the cooling block 1 or the cooling block array 7 each as a heat sink.

The electronic component 14 and the combination of the cooling channel 6 and cover 8 may be placed between the lower housing 9 and the upper housing 11. The lower housing 9 and the upper housing 11 may be prepared to be attached to each other for example in screwed, clipped or glued manner. A combination of the lower housing 9 and the upper housing 11 may at least partially enclose the electronic component 14 and the combination of the cooling channel 6 and the cover 8.

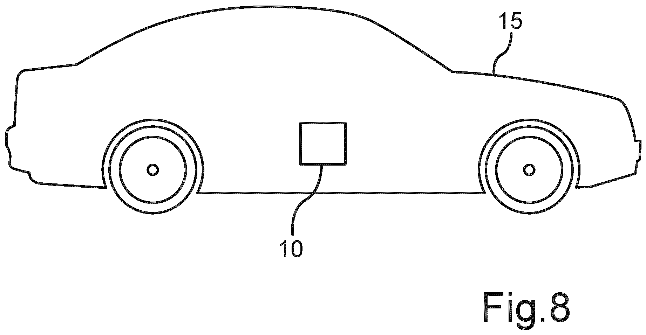

Fig. 8 shows an exemplary embodiment of a motor vehicle 15 according to the invention. The motor vehicle 15 may comprise the electronic computing device 10. The motor vehicle 15 may, for example, comprise means for recirculating or conditioning or re-cooling of the cooling fluid received by a drain from the outlet connection 13 and provided again via a source to the inlet connection 12. To this end, the motor vehicle 15 may also comprise a transportation system for the cooling fluid including, for example, one or more pumps to convey the cooling fluid from the source to the inlet connection 12 through the housing back to the outlet connection 13 and the drain and so forth.

Within a simulation of a cooling block 1 according to the invention, a temperature of the electronic component 14, in this case a system-on-chip device, could be reduced by 10°C, when compared to a different cooling block with straight through holes. An increase of a pressure drop of the cooling block 1 according to the invention compared with the different cooling block could be limited to 1.5 mbar. The pressure drop describes an additionally introduced pressure loss, when placing the cooling block 1 into the cooling channel 6. The pressure loss has to be overcome by the cooling fluid.

## Claims

1. Cooling block (1) for cooling an electronic component (14) of an electronic computing device (10) of a motor vehicle (15), wherein
- the cooling block (1) is applicable to a cooling channel (6) for guiding a cooling fluid; and
- the cooling block (1) comprises an inlet side (2) on a first side of the cooling block (1); and
- the cooling block (1) comprises an outlet side (3) on a second side of the cooling block (1); and
- the cooling block (1) comprises a through hole (4) connecting the inlet side (2) to the outlet side (3) of the cooling block (1); and
- the through hole (4) comprises an interior surface, which comprises a first protrusion (5a).

2. Cooling block (1) according to claim 1, wherein the first protrusion (5a)
- extends longitudinally along a center line (19) of the through hole (4) over a first longitudinal length (20) starting at a first longitudinal position (21); and
- extends radially to the center line (19) of the through hole (4) from a first inner radius (22) to an outer radius (23) of the through hole (4); and
- extends along a circumference of the through hole (4) over a first angle (24) beginning at a first circular position (25) at the outer radius (23).

3. Cooling block (1) according to claim 2, wherein the cooling block (1) comprises at least one first further protrusion (5a'), wherein each of the at least one first further protrusion (5a')
- extends longitudinally along the center line (19) of the through hole (4) over the first longitudinal length (20) starting at the first longitudinal position (21); and
- extends radially to the center line (19) of the through hole (4) from the first inner radius (22) to the outer radius (23) of the through hole (4); and
- extends along the circumference of the through hole (4) over the first angle (24) beginning at a respective first further circular position at the outer radius (23).

4. Cooling block (1) according to claim 3, wherein the first circular position (25) and each of the first further circular position of the at least one first further protrusion (5a') are spaced equidistantly over the circumference of the through hole (4).

5. Cooling block (1) according to any of the preceding claims 2 to 4, wherein the cooling block (1) comprises a second protrusion (5b), which
- extends longitudinally along the center line (19) of the through hole (4) over a second longitudinal length (30) starting at a second longitudinal position (31); and
- extends radially to the center line (19) of the through hole (4) from a second inner radius (32) to the outer radius (23) of the through hole (4); and
- extends along the circumference of the through hole (4) over a second angle (34) beginning at a second circular position (35) at the outer radius (23).

6. Cooling block (1) according to claim 5, wherein the cooling block (1) comprises at least one second further protrusion (5b'), wherein each of the at least one second further protrusion (5b')
- extends longitudinally along the center line (19) of the through hole (4) over the second longitudinal length (30) starting at the second longitudinal position (31); and
- extends radially to the center line (19) of the through hole (4) from the second inner radius (32) to the outer radius (23) of the through hole (4); and
- extends along the circumference of the through hole (4) over the second angle (34) beginning at a respective second further circular position at the outer radius (23).

7. Cooling block (1) according to claim 6, wherein the second circular position (35) and each of the second further circular position of the at least one second further protrusion (5b') are spaced equidistantly over the circumference of the through hole (4).

8. Cooling block (1) according to one of the preceding claims 2 to 4 and according to one of the preceding claims 5 to 7, wherein
- the cooling block (1) comprises at least one third further protrusion (5c), wherein each of the at least one third further protrusion (5c)
- extends longitudinally along the center line (19) of the through hole (4) over the first longitudinal length (20) starting at a respective first further longitudinal position; and
- extends radially to the center line (19) of the through hole (4) from the first inner radius (22) to the outer radius (23) of the through hole (4); and
- extends along the circumference of the through hole (4) over the first angle (24) beginning at the first circular position (25) at the outer radius (23); and
- the cooling block (1) comprises at least one fourth further protrusion (5d), wherein each of the at least one fourth further protrusion (5d)
- extends longitudinally along the center line (19) of the through hole (4) over the second longitudinal length (30) starting at a respective second further longitudinal position; and
- extends radially to the center line (19) of the through hole (4) from the second inner radius (32) to the outer radius (23) of the through hole (4); and
- extends along the circumference of the through hole (4) over the second angle (34) beginning at the second circular position (35) at the outer radius (23); and
- the first longitudinal position (21), each of the first further longitudinal position of the at least one third further protrusion (5c), the second longitudinal position (31) and each of the second further longitudinal position of the at least one fourth further protrusion (5d) are spaced equidistantly over a length of the through hole (4).

9. Cooling block (1) according to any one of the preceding claims, wherein the cooling block (1) comprises copper and/or a copper alloy and/or aluminum and/or an aluminum alloy.

10. Cooling block array (7) comprising at least two cooling blocks (1) according to any one of the preceding claims, wherein each respective first side of the at least two cooling blocks (1) is parallel to all other respective first sides of the at least two cooling blocks (1) and the at least two cooling blocks (1) are thermally connected to each other.

11. Electronic computing device (10) for a motor vehicle (15) comprising a housing and an electronic component (14), wherein
- the housing comprises a cooling channel (6) for guiding a cooling fluid;
- the housing comprises a cooling block (1) according to any one of the claims 1 to 9 or a cooling block array (7) according to claim 10;
- the cooling block (1) or the cooling block array (7) is located in the cooling channel (6); and
- the electronic component (14) is thermally connected to the cooling block (1) or the cooling block array (7).

12. Electronic computing device (10) according to claim 11, wherein the electronic component (14) comprises a system-on-chip and/or a system-in-package.

13. Electronic computing device (10) according to one of claims 11 or 12, wherein a thermal conductivity of the cooling block (1) and/or the cooling block array (7) is equal to or greater than a thermal conductivity of cooling channel walls spatially limiting the cooling channel (6).

14. Electronic computing device (10) according to any one of the preceding claims 11 to 13, wherein the housing comprises a cover (8) and the cover (8) is attached to the cooling channel (6), wherein the cover (8) seals the cooling channel (6) in a fluid-tight manner and the electronic component (14) and the cooling block (1) are arranged on opposite sides of the cooling channel (6).

15. Motor vehicle (15) comprising an electronic computing device (10) according to any one of claims 11 to 14.
